# EUROPEAN PATENT APPLICATION

(11) **EP 4 653 838 A1**
(43) Date of publication of application: **26.11.2025**
(21) Application number: 24177819.0
(22) Date of filing: 24.05.2024
(51) Int. Cl.: G01M 13/04, F03D 17/00

(54) **CONDITION MONITORING SYSTEM**

(71) Applicant: Siemens Gamesa Renewable Energy A/S, 7330 Brande (DK)
(72) Inventor: CASTILLO CORTINA, Carlos Eden, 21376 Salzhausen (DE)
(74) Representative: SGRE-Association

(57) **Abstract**

The invention describes a condition monitoring system (1) for a journal bearing (30B) arranged to support a rotary component (30) installed in a rotary machine (3), which condition monitoring system (1) comprises a pair of electrical terminals (11, 12) arranged on either side of an oil-filled gap (G, 303) between the journal (302) and the rotary component (30); a capacitance meter (15) connected across the terminals (11, 12) and adapted to output a measurement reading (150) indicative of capacitance (C_{30B}) across the terminals (11, 12) during operation of the rotary machine (3); and an evaluation unit (16) adapted to receive readings (150) from the capacitance meter (15) and to determine the health of the journal bearing (30B) on the basis of the measurement readings (150). The invention further describes a method of determining the health of a journal bearing (30B) on the basis of capacitance measurement readings (150) across the oil-filled gap (G, 303) between a bearing journal (302) and the supported rotary component (30) .

## Description

### Background

A journal bearing is a type of plain bearing suitable for use in various types of machine, for example to support the shaft (the "journal") of a rotary component such as a planetary gear of a gearbox. A film of oil in the gap between journal and bearing surfaces ensures smooth operation of the rotary component.

In order to avoid downtime and expense due to component failure, some kind of condition monitoring is generally implemented in such machinery in order to monitor the health of various critical components. Ideally, a condition monitoring system (CMS) would identify a potential issue before it develops into a fault.

In the case of a journal bearing used to support a planet gear, condition monitoring can be difficult to implement. It is known to deploy ultrasonic sensors in order to collect data during operation of a journal bearing, but the journal bearing must be designed around the sensor arrangement. However, it can be difficult and therefore expensive to install ultrasonic sensors in a wind turbine gearbox.

In another approach, vibration analysis may be performed using accelerometers placed to detect vibration of the rotary component, and dedicated algorithms to analyse the collected data. Such methods are effective for a roller bearing, which has a specific frequency that can be tracked during condition monitoring. However, such an approach has limited effectiveness in the case of a journal bearing, which does not have any contacting surfaces to provide a trackable reference frequency. It is also known to deploy temperature sensors, oil particle counters, electric resistance sensors etc., in prior art condition monitoring systems. However, these known condition monitoring systems can only provide limited information relating to the actual state of a journal bearing. These systems are generally unable to give a clear indication as regards the actual condition of a journal bearing, and may identify a fault only a short time before failure of the bearing.

The limitations of the known condition monitoring systems make them unsuitable for use in a wind turbine application such as a planetary gearbox, since the various possible operating modes of a wind turbine with fluctuating torque levels place high demands on all rotary components that implement journal bearings. An undetected issue in a journal bearing can result in serious damage to the gearbox, followed by downtime, loss of earnings, and costly repairs.

It is therefore an object of the invention to provide an improved way of monitoring the health of a journal bearing.

This object is achieved by the claimed journal bearing condition monitoring system and by the claimed method of performing condition monitoring on a journal bearing.

### Description

In the context of the invention, a journal bearing shall be understood to support a rotary component of a machine, for example to support a planet gear of a planetary gearbox of a wind turbine drivetrain. In the following, without restricting the invention in any way, the rotary component supported by a journal bearing is assumed to be a planet gear of a planetary gearbox. The journal bearing can be designed to suit the particular application for which it is intended. A journal bearing comprises a stationary bearing part, i.e. the journal; a sliding surface or sleeve arranged between the journal and the rotary component; and a lubricating oil film between the stationary and rotary parts. The material of the journal (e.g. steel) is generally harder than the material of the bearing's sliding surface (e.g. a aluminium alloy). A journal bearing can be designed according to various possible configurations as will be known to the skilled person. For example, the sleeve can be mounted onto the stationary journal, and the lubricating oil film is between the sleeve and the rotary component; the sleeve can be free to move between the journal and the rotary component (a "rotating sleeve" journal bearing); the sleeve can be provided as a lining inside the gear; etc. The terms "planet gear shaft" and "journal" may be used interchangeably; similarly, the terms "sleeve" and "bearing sleeve" may be used interchangeably.

The invention describes a way of determining the health of a journal bearing, i.e. a way of monitoring the condition of a journal bearing. The terms "health" and "condition" may be regarded as synonyms in the context of the invention.

According to the invention, the journal bearing condition monitoring system comprises a pair of terminals arranged on either side of the oil-filled gap, e.g. a first terminal can be arranged in electrical contact with the gear, and a second terminal can be arranged in electrical contact with the journal. The condition monitoring system further comprises a capacitance meter connected to the terminal pair and adapted to measure the capacitance across the terminals during operation of the rotary machine and to output the measured capacitance in the form of an electrical signal or measurement reading. The condition monitoring system further comprises an evaluation unit adapted to receive such readings from the capacitance meter and to determine the health of the journal bearing on the basis of the readings. In other words, in the inventive approach, condition monitoring of the journal bearing is done by observing the capacitance across the gap and deducing the health of the bearing from alterations in the observed capacitance over time.

According to the invention, the method of determining the health of a journal bearing, i.e. for performing condition monitoring of a journal bearing, comprises steps of arranging a pair of electrical terminals on either side of the oil-filled gap; connecting a capacitance meter across the terminals; and operating the capacitance meter to output readings indicative of capacitance across the terminals during operation of the rotary machine; and determining the health of the journal bearing on the basis of the readings. Since the rotary machine may have a service life of many years, it shall be understood that readings can be generated over a similar time span.

The invention is based on the insight that a journal bearing essentially behaves as a capacitor, since it comprises opposing metal surfaces separated by a gap filled with a dielectric (the lubricating oil film). Surface defects can arise during normal operation of the journal bearing during its service life. For example, an impacted particle, caught between the bearing surfaces, can cause a physical defect such as a groove, pit, ridge, etc., on a bearing surface. Equally, smaller impacted particles can lead to a gradual wearing down of one or both surfaces, thereby modifying the gap, which can in turn alter the load distribution on the bearing. Even a minor alteration to the size of the gap will alter the electric characteristics of the journal bearing. The inventor has realised that such changes can be exploited in order to deduce the condition of the bearing.

An advantage of the inventive approach is that it can determine the condition of the journal bearing at all times during its service life. Even very early stages of deterioration can be detected. In this way, the invention can be used to identify a potential fault well before it develops into an actual fault, i.e. a potential fault can be identified without having to wait for deterioration to the point of excessive vibration or excessively high temperatures, which only manifest when a fault has developed to a serious stage, affecting not only the journal bearing itself but also causing damage to neighbouring components.

A further advantage of the invention is that it can be realised at favourably low cost, since it does not require expensive sensors, and does not require any alterations to the design of the journal bearing.

Particularly advantageous embodiments and features of the invention are given by the dependent claims, as revealed in the following description. Features of different claim categories may be combined as appropriate to give further embodiments not described herein.

The invention can be applied to perform condition monitoring of a journal bearing deployed in various kinds of machine. In the following, without restricting the invention in any way, it may be assumed that the rotary machine is a planetary gearbox of a wind turbine drivetrain, and that the journal bearing supports a planet gear. In such a configuration, the planet gear is placed about the bearing sleeve, and the journal or "planet shaft" is attached to a planet carrier. The planet carrier (along with its arrangement of planet shafts) is turned by a preceding stage of the drivetrain. For example, the planet carrier of the first stage of the gearbox can be turned by the low-speed shaft of the wind turbine.

In a preferred embodiment of the invention, a wind turbine comprises a drivetrain with a planetary gearbox comprising at least one rotary component supported by a journal bearing; and an instance of the inventive condition monitoring system (CMS) arranged to perform condition monitoring on the journal bearing.

The planetary gearbox can be arranged between a low-speed shaft and the generator of the wind turbine. The low-speed shaft of the drivetrain is arranged to turn the planet carrier of the first stage of the gearbox. The planetary gearbox may comprise several stages. At least the first stage comprises a plurality of planet gears, each supported by a journal bearing. Depending on the dimensions of the gearbox, a first-stage planet gear and its bearing can be relatively large. For example, the diameter of the planet shaft (i.e. the journal) can be in the order of 350 mm, and the bearing can have a nominal clearance or gap in the order of 0.3 mm with an operational clearance of about 1 µm (loaded side).

As explained above, a planet gear is placed about a bearing sleeve, which in turn is arranged about the journal or "planet shaft", which in turn is attached to a planet carrier. As explained above, the bearing sleeve can be mounted to the journal and therefore stationary; the sleeve can be free to rotate between journal and gear; the sleeve can be mounted to the gear. Regardless of the chosen configuration, the terminals of the inventive journal bearing CMS are arranged across the gap between the journal and the gear. This can be realized in any suitable manner. In a particularly preferred embodiment of the invention, the terminal arranged in electrical contact with the gear comprises a spring-loaded carbon brush. In a particularly preferred embodiment of the invention, the spring-loaded carbon brush is arranged to make contact with the front face (the upwind-facing surface) of the planet gear. To this end, a cavity or recess can be formed in the planet carrier to accommodate such a carbon brush for each of the monitored planet gear bearings. The carbon brush can press against the essentially flat upwind face of the planet gear. Alternatively, to ensure favourable electrical contact at all times, the planet gear can be manufactured to include a raised annulus or ring on its front face, and the carbon brush can be positioned to press against this raised ring.

Since a planet gear is carried by a planet carrier that rotates about the sun gear, i.e. about axis of rotation of the gearbox, the terminals, and any wires between the terminals and the capacitance meter, must be arranged in consideration of this aspect. Therefore, in a particularly preferred embodiment of the invention, an electrical connection between the capacitance meter and a terminal is secured to or supported by a rotating part of the gearbox, preferably the planet carrier of that stage.

The measured readings can be passed to an evaluation unit located in the hub. The evaluation unit can be realised as part of an already available I/O module of the wind turbine controller, e.g. an already available module of the pitch controller terminal block, which turns with the hub and which can be connected by a slip ring interface to a stationary stage of the wind turbine controller, as will be known to the skilled person. In a particularly preferred embodiment of the invention, the journal bearing CMS can be battery-operated and integrated in the planet carrier, with a transmitter for sending the data over a wireless interface to a higher-level CMS of the wind turbine, or to the wind turbine controller.

The inventive journal bearing CMS can be configured to perform condition monitoring on any number of the planet gear bearings. In a particularly preferred embodiment of the invention, the inventive CMS can be configured to perform condition monitoring of at least the set of planet gear bearings in the first stage of the gearbox. At times in the following, the invention will be explained in terms of a single journal bearing, however it shall be understood that the inventive condition monitoring system can be configured to simultaneously monitor the health of several journal bearings.

The capacitance meter can be realised using any appropriate electrical circuit. Preferably, the capacitance meter is realized as a suitable bridge circuit such as a Wien bridge, a Wheatstone bridge, etc. The capacitance meter can be realised to essentially continually measure the capacitance across the terminals (i.e. across the journal bearing) or to measure at predetermined intervals (e.g. every 10 minutes). A measurement reading generated as output of the capacitance meter can be in the form of an analogue signal, e.g. a voltage or current indicative of the measured capacitance. Equally, a measurement reading can be in the form of a digital signal. Over time, the evaluation unit receives a series of readings from the capacitance meter. These can be processed in any suitable manner. In a preferred embodiment, the inventive system for monitoring the health of the journal bearing(s) is compatible with a higher-lever condition monitoring system. For example, a wind turbine may deploy a condition monitoring system which collects data from various sub-systems and which transmits relevant data by SCADA to a wind park control centre. The evaluation unit of the inventive journal bearing CMS can be a stand-alone unit. In a particularly preferred embodiment of the invention, the evaluation unit can be realised in the form of software modules running on a processor of a wind turbine controller.

The capacitance of a "healthy" journal bearing can be expected to fluctuate within a certain acceptable range. This range can be established, for example using the same kind of capacitance meter, before installing the journal bearing in the rotary machine and/or by performing condition monitoring of a new (i.e. fault-free or "pristine") journal bearing installed in an operational wind turbine. The fluctuation of capacitance within that acceptable range can be regarded as a "capacitance signature" which reflects the behaviour of the journal bearing under normal operating conditions.

In a rotary machine such as a planetary gearbox, various component parts can comprise electrically conductive material and may be in direct or indirect contact with each other. Any such component in contact with the journal bearing being monitored by the inventive CMS could distort the measurement of capacitance across the journal bearing. Therefore, in a preferred embodiment of the invention, insulation is provided at one or more suitable locations in order to electrically isolate the rotary component from other components of the rotary machine. The electrical insulation is placed to prevent transmission of electric currents to any other conductive part as a result of the voltage applied by the capacitance meter across the terminals. In this way, the capacitance meter can reliably measure the capacitance of the journal bearing. For example, an insulating coating can be applied to one or more surfaces of the planet carrier in order to electrically isolate a journal bearing from any other journal bearings in the first gearbox stage. Preferably, placement of the electrical insulation is determined before assembly of the rotary machine, for example during the design phase of a planetary gearbox.

Over the service life of the gearbox, the evaluation unit compares each new reading with an expected value, for example to see if the new reading lies within the acceptable range. As long as the readings tend to lie within this range of acceptable values, the inventive method concludes that the journal bearing is healthy.

In a preferred embodiment of the invention, the evaluation unit can issue a report when the readings tend to lie outside of the acceptable range. The report can be in the form of an alarm if a significant number of the latest readings fall outside of the acceptable range. Equally, an alarm can be issued by the evaluation unit if the readings lie outside the acceptable range over a predefined duration, for example if significant deviations are being observed over several minutes, or if slight deviations are being observed over several days.

Maintenance of the components of a machine such as a wind turbine drivetrain may be managed on the basis of condition numbers. For example, a component with a low condition number (e.g. 1 or 2) may be regarded as healthy and not in need of any service; a high condition number (e.g. 4 or 5) may mean that the component is faulty and should be replaced; a mid-range number (e.g. 3) may indicate that the component needs routine servicing. Therefore, in a preferred embodiment of the invention, the evaluation unit is realized to output a condition number for each monitored journal bearing. The wind turbine controller or wind park controller, upon receiving a mid-range condition number for a journal bearing of the gearbox, can schedule a gearbox exchange in good time, thereby avoiding the expense of a serious fault in the gearbox.

In a further preferred embodiment of the invention, the evaluation unit is realised to identify a trend in the collected readings, for example to identify an upwards trend or a downwards trend in the readings of each monitored bearing. For example, a downwards trend (i.e. a gradually decreasing capacitance) may indicate wear on the bearing surfaces of a specific planet gear.

Such a condition trend cannot be established using prior art condition monitoring system, since these are unable to distinguish between a fault-free bearing and a bearing in an early stage of deterioration. This is because the information collected by a prior art vibration-based or temperature-based condition monitoring system can only identify an already established fault (e.g. a fault that manifests in measurable vibration and/or measurable temperature increase), but cannot identify any early signs that might indicate a potential fault. Such condition monitoring systems cannot identify an early stage of deterioration that may lead to serious damage requiring drastic response such as shutting down the wind turbine in order to carry out the (usually expensive) repairs on the gearbox.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Figures 1 and 2 show a gearbox of the type used in a wind turbine drivetrain;
Figure 3 shows details of a journal bearing used in the gearbox of Figure 1;
Figures 4 and 5 illustrate exemplary embodiments of the inventive condition monitoring system;
Figures 6 and 7 illustrate various issues that may arise in a journal bearing during operation;
Figure 8 shows exemplary data collected by the inventive condition monitoring system;
Figure 9 illustrates data collected by a prior art method.

In the diagrams, like numbers refer to like objects throughout. Objects in the diagrams are not necessarily drawn to scale.

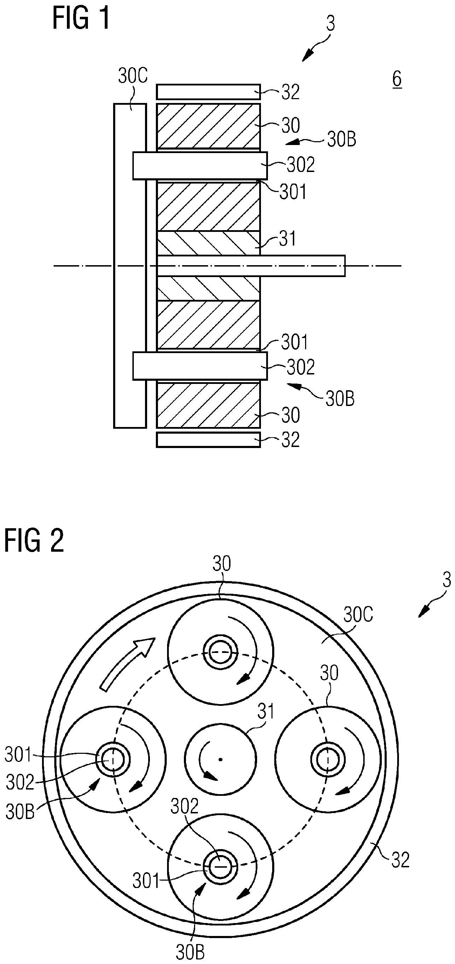

Figures 1 - 5 illustrate an exemplary embodiment of the inventive journal bearing CMS 1 deployed in a common type of wind turbine gearbox 3. The major components of the gearbox 3, as shown in Figure 1, are the first stage planet carrier 30C (which is turned by the low-speed shaft), a ring gear 32, a set of planet gears 30, and a sun gear 31 (for clarity, the meshing gear teeth are not shown, and the subsequent gearbox stages are not shown). Each first-stage planet gear 30 is supported by a journal bearing 30B. During operation of the wind turbine, the low-speed shaft 2 and the planet carrier 30C turn as one. As illustrated in Figure 2, the stationary ring gear 32 and the rotating planet carrier 30C result in rotation of the planet gears 30, causing the sun gear 31 to turn about its axis 3A. Each planet shaft 302 or journal 302 describes a circle (orbit) about the sun gear 31 as indicated by the dashed line, and each planet gear 30 rotates about its own axis, i.e. about its journal 302.

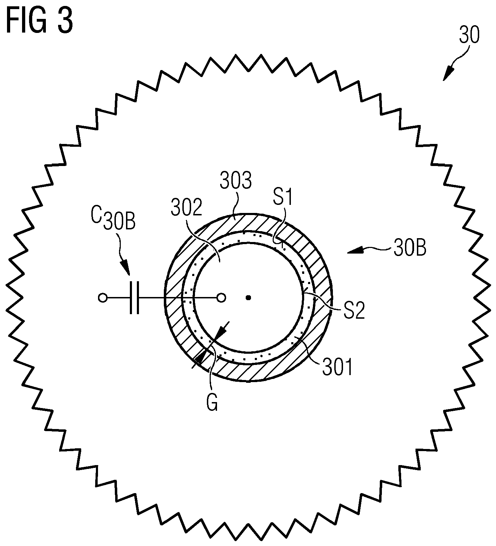

Figure 3 shows a cross-section through a planet gear 30 in a commonly used wind turbine drivetrain configuration. Here, the gear 30 is supported by a journal bearing 30B which comprises a sleeve 301 mounted about a journal 302, and an lubricating oil film 303 in the gap G between the stationary elements 301, 302 and the rotary gear 30. The invention is based on the insight that the assembly 30, 303, 30B essentially acts as a capacitor when a voltage is applied across the gap G. The capacitance can be measured across any two suitable points, for example across the journal 302 and the planet gear 30 itself. The resulting "capacitor" is indicated by the electrical symbol. Under the assumption that other factors remain constant, the capacitance C_{30B} of the bearing 30B is determined by the size of the gap G and the permittivity of the dielectric or oil 303. The gap G between the bearing surfaces S1, S2 may change during normal operation of the wind turbine, since loads on the gearbox 3 can be expected to fluctuate. Equally, the composition of the lubricating oil film 303 may change, so that its permittivity may increase or decrease. The capacitance C_{30B} of a journal bearing 30B (i.e. the capacitance of the assembly 30, 303, 30B) can therefore be expected to fluctuate within a certain acceptable range.

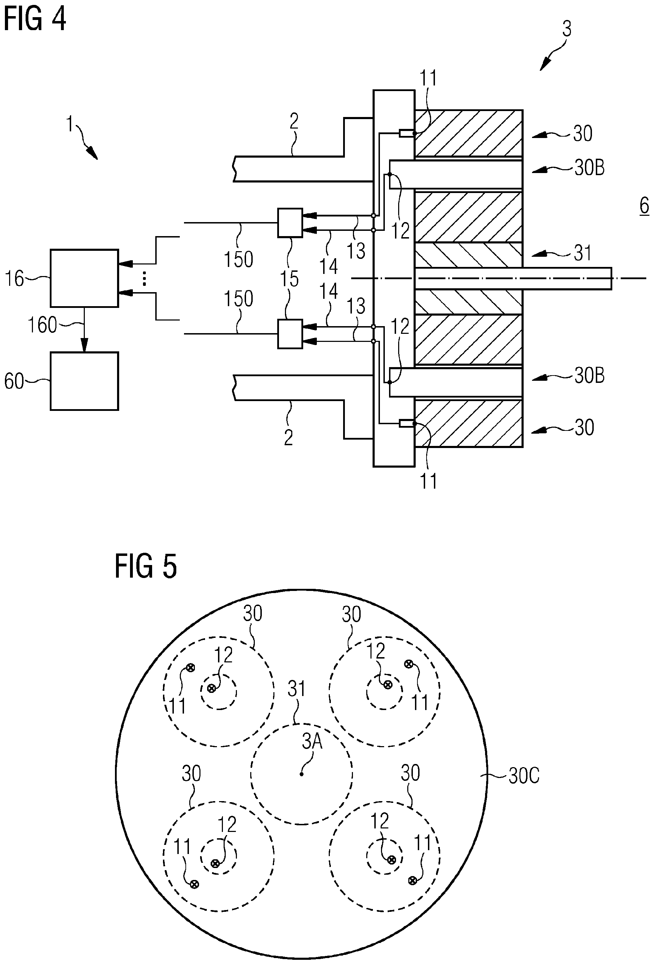

The inventive journal bearing CMS 1 exploits the capacitive behaviour of a journal bearing by placing electrical contacts 11, 12 at appropriate locations as shown in Figure 4 and Figure 5. The diagrams show how the contacts or terminals 11, 12 might be placed to measure capacitance of a journal bearing 30B and how the wires or cables 13, 14 from these terminals 11, 12 might be arranged. For example, wires 13, 14 from the terminals 11, 12 can lead through the planet carrier 30C to the hub of the wind turbine by arranging them in the hollow interior of the low-speed shaft 2 as indicated.

The diagram shows a first electrical contact 11 in the form of a carbon brush 11 in contact with the upwind face of a planet gear 30 as this turns about its journal 302. A wire or cable 13 leads from the brush 11 to the exterior of the gearbox 3. A second terminal 12 is arranged in contact with the journal 302 of the planet gear 30. A wire or cable 14 leads to the exterior of the gearbox 3. The second electrical contact 12 can be directly secured to the journal 302, for example by soldering, by means of a clamp or fastener, etc., since the planet shafts (journals) 302 are secured to the planet carrier 30C. The electrical contacts 11, 12 and their wires 13, 14 are stationary with respect to the planet carrier 30C and therefore also "orbit" about the axis of rotation of this gearbox stage. A carbon brush will eventually wear down and will need to be replaced. To this end, a carbon brush 11 is preferably arranged so that it can be accessed with relatively little effort, for example through service/inspection apertures provided in the housing of the gearbox first stage, during maintenance of the inventive CMS 1.

Each of the planet gears 30 can be included in the condition monitoring system in this way, for example a gearbox with four planet gears in its first stage can have four such sets of contacts 11, 12 and wires 13, 14 as illustrated in the simplified elevation view of Figure 5. Of course, the first stage of the gearbox 3 can have any number of planet gears, as will be known to the skilled person.

Each pair of terminals 11, 12 can be connected to a capacitance meter 15 as indicated in Figure 4 (a multiplexer or other switching circuit can connect a single capacitance meter to each of the four gear/bearing assemblies in turn). The capacitance of a bearing 30B can be measured at suitable intervals, for example every quarter hour, or at shorter intervals if the readings indicate a potential fault. An analogue-to-digital converter (ADC) can convert the electrical signal to a digital reading 150 which is forwarded to an evaluation module 16. The evaluation module 16 can process the received values or readings 150 for a bearing 30B in a number of ways and report its findings, for example as a fault status 160 for that bearing 30B, sent to the wind turbine controller 60.

The measured readings 150 can be passed to an evaluation unit 16 located in the hub. The evaluation unit 16 can be realised as part of an already available I/O module such as a pitch controller terminal block, which turns with the hub and which can be connected by a slip ring interface to a stationary stage of the wind turbine controller, as will be known to the skilled person.

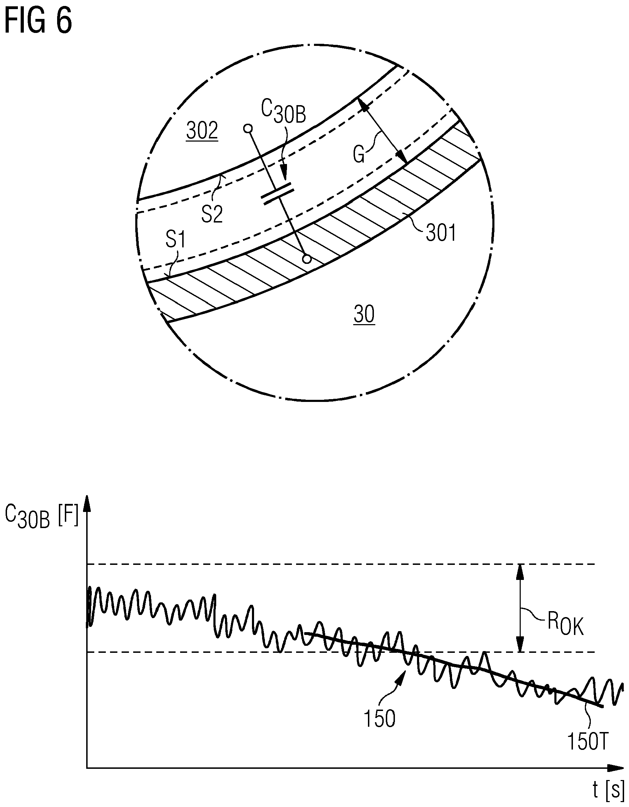

As explained above, the capacitance C_{30B} of a bearing 30B can be expected to fluctuate within a certain acceptable range R_{OK} as long as the bearing is "healthy". The invention is based on the insight that the capacitance C_{30B} of the bearing 30B will change beyond this range R_{OK} if the bearing surfaces S1, S2 become damaged. For example, worn or eroded surfaces will widen the gap on the non-loaded side and result in an uneven gap on the loaded side, thereby altering the "capacitance signature" of the bearing. Such damage may be restricted to a relatively small portion of the bearing, or may extend over much of the bearing surfaces. Degradation of the surfaces S1, S2 relative to their initial state may lead to a noticeable reduction in capacitance of the bearing 30B. Figure 6 shows a partial cross-section through a journal bearing 30B to illustrate (in a very simplified manner) eroded bearing surfaces S1, S2 relative to an initial surface profile (indicated by the ghost lines) and a corresponding decrease in capacitance (here, the sliding surface 301 is provided as a lining inside the gear 30). Even though such damage is usually restricted to a relatively small region in the bearing, it can measurably alter the capacitance signature of the bearing owing to the reduced clearance on the loaded region of the bearing and the increased clearance on the non-loaded region.

The example shows how the capacitance readings 150 may move out of the acceptable range R_{OK} towards lower, "problematic" levels, as indicated by the downward trend 150T. Any such departure from the acceptable range R_{OK} may be observed over several days, weeks or even months, depending on the severity of degradation.

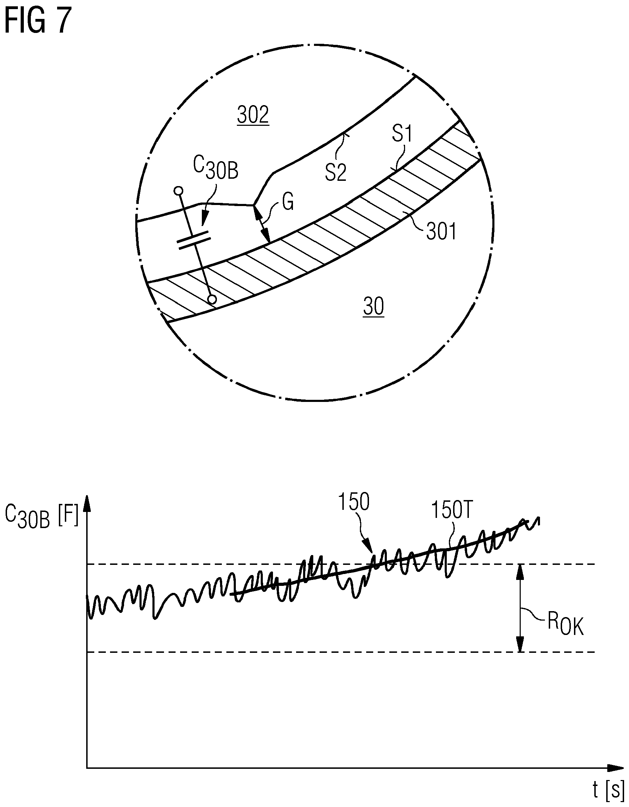

An increase in capacitance C_{30B} may be observed as a result of a physical change to a bearing surface as illustrated in Figure 7, for example when material of one or both surfaces S1, S2 protrudes into the gap G. The narrower gap G between the opposing surfaces S1, S2 can result in an increase in capacitance, away from the acceptable range R_{OK} towards undesirably higher levels.

Equally, a deterioration of the oil quality, for example too many particulate contaminants in the oil may also cause the capacitance readings 150 to increase, leaving the acceptable range R_{OK} towards undesirably higher levels, as indicated by the upward trend 150T.

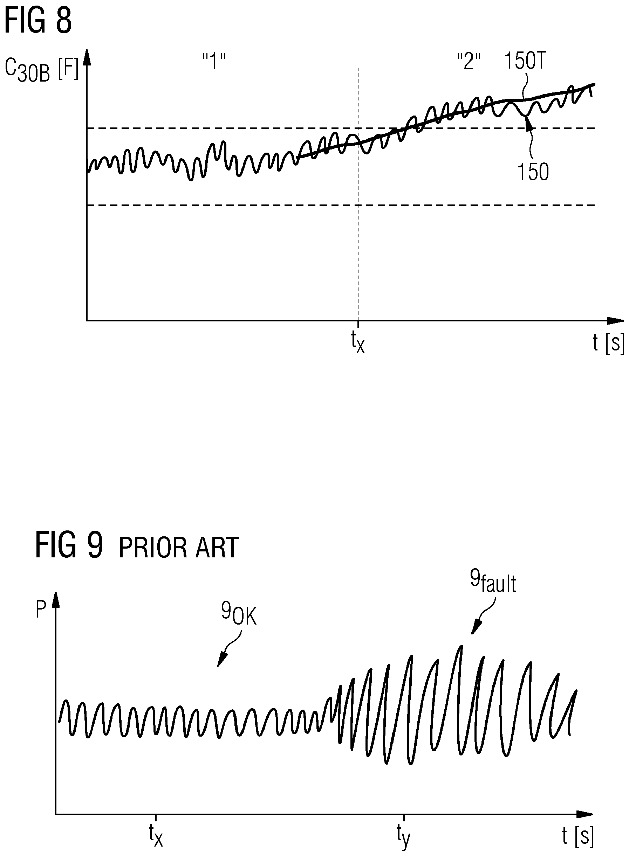

Figure 8 is a schematic representation of data collected by the inventive method. This diagram illustrates the information obtained from the inventive condition monitoring system, used to monitor the health of a journal bearing as described above. Initially, the bearing is pristine and behaves as it should, so that the readings 150 lie within the acceptable range R_{OK}. A condition number for this bearing might therefore be "1", indication that all is normal. At some time t_{X} during the service life of the gearbox 3, significant surface degradation may occur in a journal bearing 30B, altering the capacitance C_{30B} of the assembly. While the surface degradation initially does not affect the bearing's behaviour (the planet gear still functions correctly), the inventive CMS 1 is able to detect the change very soon, since the capacitance meter readings 150 will move (perhaps very gradually) outside the acceptable range R_{OK}, and will follow a trend 150T that departs from the average value in the acceptable range. Therefore, even though there is no actual fault at that time, the output 160 of the evaluation unit 16 reports the issue, in this case as the next condition number "2", indicating that this bearing may develop problems. The wind turbine controller 60 can increase the rate at which readings are collected for this bearing. In this way, the inventive method helps avoid a situation in which such degradation of a journal bearing goes undetected until it develops into an actual fault.

Regardless of the cause, a departure from the acceptable range R_{OK} can be interpreted as an indication that the condition of the bearing 30B has deteriorated and may warrant closer attention. In that case, further relevant data may be collected, for example particle counts for oil samples collected from that bearing. A high particle count could then be interpreted as evidence of a problem in that journal bearing. If the observed deviation is reported by the evaluation unit 16 as "significant", i.e. indicative of a developing fault, the wind turbine controller 60 may avoid high-load operating modes until an inspection (using indirect indicators) can be performed. If the observed deviation is reported by the evaluation unit 16 as "critical", the wind turbine controller 60 may initiate shutdown and schedule an immediate inspection.

As shown in the above examples, the evaluation unit 16 can be realised as a module of a higher-level condition-monitoring system 60 which reports to the wind turbine. Equally, the evaluation unit 16 can be realised as a stand-alone unit that can report to the wind turbine controller.

Figure 9 is a schematic representation of data collected by a prior art method, for example a method that relies on monitoring a suitable parameter P such as vibration of a journal bearing. This diagram uses the example given above, with surface degradation commencing at time t_{X}. Initially, the bearing is fault-free and behaves as it should, with an acceptable vibration profile (e.g. within an acceptable peak-to-peak amplitude), so that the prior art condition monitoring system reports a "no fault" status 9_{OK}. The minor surface degradation does not affect the bearing's behaviour in any way measurably by the prior art condition monitoring system, which continues to report the "no fault" status 9_{OK} for some time. The surface degradation becomes more serious, ultimately manifesting as significant vibration in the journal bearing, so that the condition monitoring system 1 finally reports a fault status 9_{fault} at time t_{y}. However, at this much later stage (e.g. weeks after the bearing started to deteriorate), damage to the bearing may be so severe that the wind turbine must be immediately shutdown so that the gearbox can be repaired. A prior art condition monitoring system that deploys temperature sensors may suffer from the same drawbacks, since a minor surface degradation will not result in elevated temperatures, and such a condition monitoring system will also continue to report the "no fault" status 9_{OK} after time t_{X} until the surface degradation leads to excessive friction and a corresponding rise in temperature.

Although the present invention has been disclosed in the form of preferred embodiments and variations thereon, it will be understood that numerous additional modifications and variations could be made thereto without departing from the scope of the invention. For example, the connections between the terminals and the evaluation unit can be realised in any suitable manner and are not limited to the embodiments shown in the drawings. For example, the inventive journal bearing CMS be electrically isolated from other rotary components. Furthermore, the inventive condition monitoring system can be used in any stage of a gearbox.

For the sake of clarity, it is to be understood that the use of "a" or "an" throughout this application does not exclude a plurality, and "comprising" does not exclude other steps or elements.

## Claims

1. A condition monitoring system (1) for a journal bearing (30B) arranged to support a rotary component (30) installed in a rotary machine (3), which condition monitoring system (1) comprises
- a pair of electrical terminals (11, 12) arranged on either side of an oil-filled gap (G, 303) between the journal (302) and the rotary component (30);
- a capacitance meter (15) connected across the terminals (11, 12) and adapted to output a measurement reading (150) indicative of capacitance (C_{30B}) across the terminals (11, 12) during operation of the rotary machine (3); and
- an evaluation unit (16) adapted to receive readings (150) from the capacitance meter (15) and to determine the health of the journal bearing (30B) on the basis of the measurement readings (150).

2. A condition monitoring system according to the preceding claim, wherein a first terminal (11) is arranged in electrical contact with the rotary component (30).

3. A condition monitoring system according to the preceding claim, wherein the first terminal (11) comprises any of: an electrical contact brush, a spring-loaded carbon brush.

4. A condition monitoring system according to any of the preceding claims, wherein the evaluation unit (16) is adapted to compare a received measurement reading (150) with an acceptable range (R_{OK}) of capacitance for that journal bearing (30B).

5. A condition monitoring system according to the preceding claim, wherein the evaluation unit (16) is adapted to issue an alarm (160) when a received measurement reading (150) is outside the acceptable range (R_{OK}).

6. A condition monitoring system according to any of the preceding claims, wherein the evaluation unit (16) is adapted to output a condition number (160) for the journal bearing (30B).

7. A wind turbine (6) comprising
- a drivetrain (2, 3, 4) with a planetary gearbox (3) comprising at least one rotary component (30) supported by a journal bearing (30B); and
- a condition monitoring system (1) according to any of claims 1 to 6, arranged to perform condition monitoring on at least one journal bearing (30B).

8. A wind turbine according to the preceding claim, wherein a rotary component (30) is a planet gear.

9. A wind turbine according to claim 7 or claim 8, wherein an electrical connection (13, 14) between the capacitance meter (15) and a terminal (11, 12) extends through a planet carrier (30C).

10. A wind turbine according to any of claims 7 to 9, wherein the evaluation unit (16) is realised as a module of a controller (60) of the wind turbine (6).

11. A wind turbine according to any of claims 7 to 10, wherein the gearbox (3) comprises a plurality of stages, and wherein the condition monitoring system (1) is configured to perform condition monitoring on at least the journal bearings (30B) of the planet gears (30) of the first gearbox stage.

12. A method of determining the health of a journal bearing (30B) arranged to support a rotary component (30) installed in a rotary machine (3), which method comprises steps of
- arranging a pair of electrical terminals (11, 12) on either side of an oil-filled gap (G, 303) between the bearing journal (302) and the rotary component (30);
- connecting a capacitance meter (15) across the terminals (11, 12) and operating the capacitance meter (15) to generate measurement readings (150) indicative of capacitance across the terminals (11, 12) during operation of the rotary machine (3); and
- determining the health of the journal bearing (30B) on the basis of the measurement readings (150).

13. A method according to the preceding claim, comprising steps of analysing the measurement readings (150) to identify a trend (150T) relative to an acceptable range (R_{OK}) of values.

14. A method according to any of the preceding method claims, comprising a step of providing electrical insulation to electrically isolate the journal bearing (30B) from other components of the rotary machine (3).

15. A computer program product comprising a computer program that is directly loadable into a memory of a controller (60) of a wind turbine (6) according to any of claims 7 to 11, and which comprises program elements for performing steps of the method according to any of claims 12 to 14 when the computer program is executed by the controller (60).
